# EUROPEAN PATENT APPLICATION

(11) **EP 1 870 940 A1**
(43) Date of publication of application: **26.12.2007**
(21) Application number: 06731613.3
(22) Date of filing: 11.04.2006
(51) Int. Cl.: H01L 29/78

(54) **SEMICONDUCTOR DEVICE**

(30) Priority: 13.04.2005 JP 2005115952
(71) Applicant: ROHM CO., LTD., Kyoto-shi, Kyoto 615-8585 (JP)
(72) Inventor: TAKAISHI, Masaru, ROHM CO., LTD., Kyoto-shi, Kyoto 615-8585 (JP)
(74) Representative: Steil, Christian
(86) International application number: PCT/JP2006/307666
(87) International publication number: WO 2006/112305

(57) **Abstract**

A semiconductor device is disclosed which has a shorter turn-on time. The semiconductor device includes an epitaxial layer, two base regions embedded in a surface portion of the epitaxial layer, source regions respectively embedded in the base regions, a drain region including at least a portion of the epitaxial layer excluding the base regions, and a gate electrode provided on the epitaxial layer with the intervention of an insulation film with ends thereof respectively opposed to surfaces of the two base regions. The drain region is arranged so that depletion layers respectively extending from boundaries between the drain region and the two base regions are connected to each other in an OFF state in a portion of the drain region located between the two base regions.

## Description

### TECHNICAL FIELD

The present invention relates to a semiconductor device and, particularly, to a DMOSFET (double diffusion MOSFET) or an IGBT (insulated gate bipolar transistor) which serves as a power transistor.

### PRIOR ART

A DMOSFET or an IGBT is conventionally employed as a power transistor which serves as a switching device capable of controlling a large electric current at a high voltage (for example, Patent Document 1).

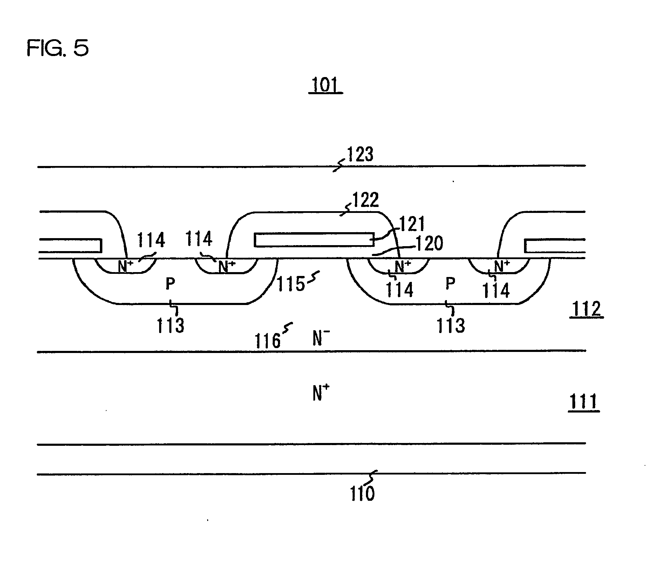

Fig. 5 shows a sectional view of a prior art DMOSFET. The DMOSFET 101 includes an N⁻-type epitaxial layer 112 provided on a front surface of an N⁺-type semiconductor substrate 111 and having a lower impurity concentration than the semiconductor substrate 111. A rear surface of the semiconductor substrate 111 is covered with a metal, which serves as a drain electrode 110.

At least two P-type diffusion layers each serving as a base region 113 are embedded in a part of a surface portion of the epitaxial layer 112 (in a portion of the epitaxial layer 112 contiguous to the surface of the epitaxial layer). Two N⁺-type diffusion layers each serving as a source region 114 are embedded in a part of a surface portion of each of the base regions 113. A portion 115 of the epitaxial layer 112 located between the two base regions 113, 113 is a part of a drain region, and herein referred to as a drain JFET region, since the portion 115 acts as a JFET in an ON state. The other portion 116 of the epitaxial layer 112 present between the drain JFET region 115 and the semiconductor substrate 111 is herein referred to as a drain epitaxial region. The semiconductor substrate 111 is also a part of the drain region.

A gate electrode 121 is provided on the surface of the epitaxial layer 112 with the intervention of a gate insulation film 120. The gate electrode 121 is arranged so that ends thereof are opposed to surfaces of the two base regions 113, 113. The gate electrode 121 is covered with an insulation film 122. A patterned metal interconnection 123 is provided over the insulation film 122. The metal interconnection 123 serves as a source electrode. The metal interconnection 123 is connected to the base regions 113 and the source regions 114 through ohmic contacts via contact holes formed by etching away parts of the insulation film 122. The gate electrode 121 is patterned, and ends of the resulting pattern are connected to other metal interconnections though not shown.

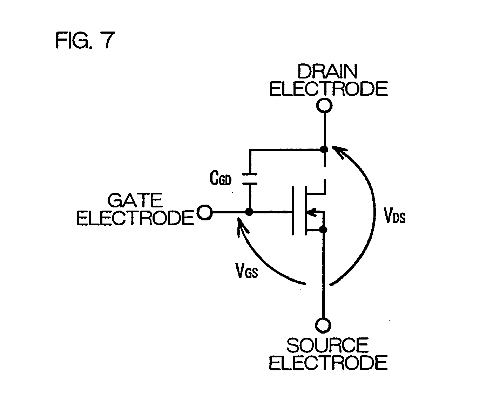

The DMOSFET 101 is typically represented by a circuit diagram shown in Fig. 7. A drain-source voltage V_{DS} is applied between a drain electrode (corresponding to the drain electrode 110 of Fig. 5) and a source electrode (corresponding to the aforesaid source electrode). A gate-source voltage V_{GS} is applied between a gate electrode (corresponding to the gate electrode 121 of Fig. 5) and the source electrode. A gate-drain capacitance C_{GD} will be described later.

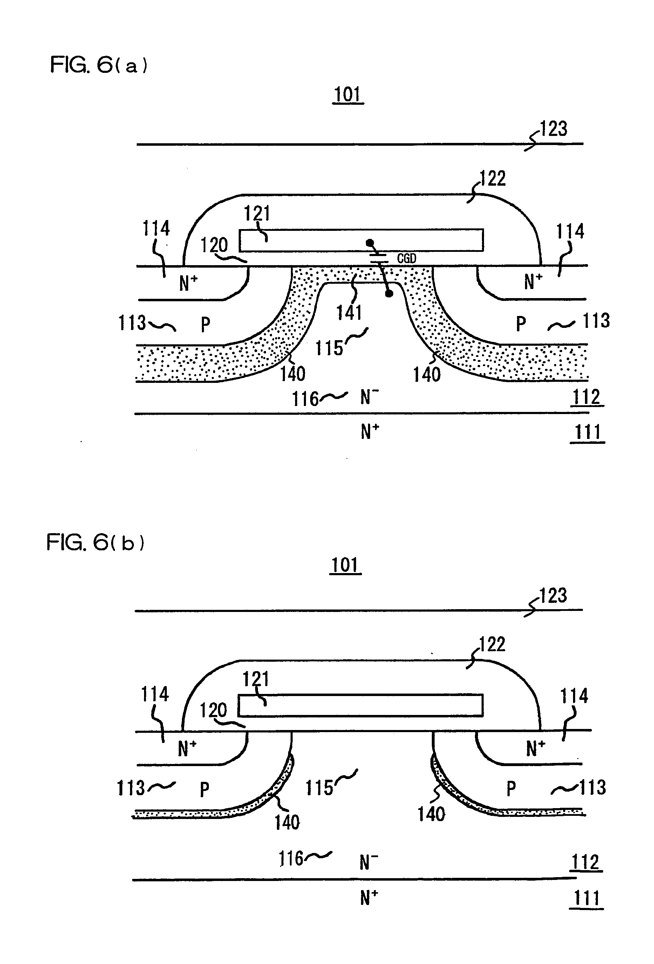

Fig. 6 (a) is a sectional view schematically illustrating an OFF state of the DMOSFET 101. Fig. 6 (b) is a sectional view schematically illustrating an ON state of the DMOSFET 101. If the gate-source voltage V_{GS} is lower than a threshold (predetermined positive value), the DMOSFET 101 is in the OFF state. In the OFF state, thick depletion layers 140 are formed in portions of the drain JFET region 115 and the drain epitaxial region 116 adjacent to boundaries of the base regions 113 as shown in Fig. 6(a). Where the base regions 113 each have a much higher impurity concentration than the drain JFET region 115 and the drain epitaxial region 116, the depletion layers 140 generally spread only into the drain JFET region 115 and the drain epitaxial region 116. Where the drain JFET region 115 and the drain epitaxial region 116 each have an impurity concentration of 4×10¹⁶/cm³ and the gate-source voltage V_{GS} and the drain-source voltage V_{DS} are 0V and 20V, respectively, for example, the drain-base depletion layers each have a width of about 0.8 µm. Since a voltage of -20 V relative to the drain JFET region 115 is applied to the gate electrode 121, a depletion layer 141 is formed adjacent to the surface of the drain JFET region 115.

If the gate-source voltage V_{GS} is higher than the threshold, on the other hand, the DMOSFET 101 is in the ON state. In the ON state, channel layers are formed in surface portions of the base regions 113 (opposed to the ends of the gate electrode 121). An electric current flows from the drain electrode 110 through the semiconductor substrate 111, the drain epitaxial region 116, the drain JFET region 115, the channel layers of the base regions 113 and the source regions 114. The resistance (ON resistance) observed between the drain electrode and the source electrode in the ON state is the sum of resistance components present in an electric current path extending from the drain electrode 110 to the source regions 114 and, particularly, the resistance component of the drain JFET region 115 is contributable significantly to the ON resistance.

In the ON state, the drain-source voltage V_{DS} is reduced, so that thin depletion layers 140 are formed only in a deeper portion of the drain JFET region 115 (closer to the semiconductor substrate 111) and the drain epitaxial region 116 as shown in Fig. 6(b). When a larger electric current flows through the drain JFET region 115, a voltage applied to the resistance component of the drain JFET region 115 is increased. Therefore, the widths of the depletion layers 140 are increased in the deeper potion. Correspondingly, the width of the electric current path in the drain JFET region 115 is reduced, so that the resistance is further increased. Thus, the ON resistance is increased or decreased by the depletion layers 140, whereby the drain JFET region 115 acts as a JFET. Therefore, the prior art DMOSFET 101 is designed so that the drain JFET region 115 has a greater lateral length, i.e., the two base regions 113, 113 are spaced a greater lateral distance on the order of about 3 µm from each other to suppress the increase in the resistance attributable to the resistance component of the drain JFET region 115.
Patent Document 1: Japanese Unexamined Patent Publication No. 7-169950

### DISCLOSURE OF THE INVENTION

### PROBLEMS TO BE SOLVED BY THE INVENTION

With a recent trend toward lower power consumption, a DC/DC converter is increasingly required to have a reduced output voltage not only in portable devices but also in stationary devices. A switch for use in such a DC/DC converter should have a shorter ON period, and a DMOSFET or a power transistor to be used as the switch is required to have a high speed switching capability. Therefore, the time required for turning on the DMOSFET (shifting the DMOSFET from the OFF state to the ON state), i.e., a turn-on time, should be shortened.

The turn-on time is significantly influenced by the gate-drain capacitance C_{GD}. In the OFF state (in which the gate-source voltage V_{GS} is lower than the threshold), the capacitance is the sum of serially connected capacitances of the gate insulation film 120 and the depletion layer 141, as shown in Fig. 6(a). The depletion layer 141 has a capacitance value which is inversely proportional to the width thereof. Therefore, if the depletion layer 141 has a smaller width, the capacitance value of the depletion layer 141 is increased. As a result, the capacitance C_{GD} which is the sum of the serially connected capacitances of the depletion layer 141 and the gate insulation film 120 is increased. Conversely, if the depletion layer 141 has a greater width, the capacitance value of the depletion layer 141 is reduced and hence the gate-drain capacitance C_{GD} is reduced.

Consequently, the inventor of the present invention came up with an idea that the gate-drain capacitance C_{GD} can be reduced to shorten the turn-on time by forcibly increasing the width of the depletion layer 141 in the OFF state.

It is an object of the present invention to provide a semiconductor device which has a shorter turn-on time.

### MEANS FOR SOLVING THE PROBLEMS

A semiconductor device according to one aspect of the present invention comprises an epitaxial layer, two base regions embedded in a surface portion of the epitaxial layer, source regions respectively embedded in the two base regions, a drain region including at least a portion of the epitaxial layer excluding the two base regions, and a gate electrode provided on the epitaxial layer with the intervention of an insulation film with ends thereof respectively opposed to surfaces of the two base regions. The drain region is arranged so that depletion layers respectively extending from boundaries between the drain region and the two base regions are connected to each other in an OFF state in a portion of the drain region located between the two base regions.

The portion of the drain region located between the two base regions in the epitaxial layer preferably has a higher impurity concentration than the other portion of the drain region in the epitaxial layer.

A semiconductor device according to another aspect of the present invention comprises an epitaxial layer, first and second base regions embedded in a surface portion of the epitaxial layer, a first source region embedded in the first base region, a second source region embedded in the second base region, a drain region including at least a portion of the epitaxial layer excluding the first and second base regions, a first gate electrode provided on the epitaxial layer with the intervention of an insulation film in opposed relation to a surface of the first base region, and a second gate electrode provided on the epitaxial layer with the intervention of an insulation film in opposed relation to a surface of the second base region and spaced a predetermined distance from the first gate electrode. A portion of the drain region located between the first base region and the second base region in the epitaxial layer has a higher impurity concentration than the other portion of the drain region in the epitaxial layer. In an OFF state, depletion layers respectively extending from boundaries between the drain region and the first and second base regions spread beyond portions of the drain region opposed to the first and second gate electrodes in the portion of the drain region located between the first base region and the second base region in the epitaxial layer.

A semiconductor device according to further another aspect of the present invention comprises an epitaxial layer, first and second base regions embedded in a surface portion of the epitaxial layer, a first source region embedded in the first base region, a second source region embedded in the second base region, a first drain region defined as a portion of the epitaxial layer located between the first base region and the second base region, a second drain region defined as a portion of the epitaxial layer excluding the first base region, the second base region and the first drain region, and a gate electrode provided on the epitaxial layer with the intervention of an insulation film with at least a part thereof opposed to the first drain region. The first drain region has a higher impurity concentration than the second drain region. In an OFF state, a depletion layer spreads throughout a portion of the first drain region opposed to the gate electrode.

The epitaxial layer is preferably provided on a front surface of a semiconductor substrate, and a drain electrode is preferably provided on a rear surface of the semiconductor substrate.

In the semiconductor device according to any of the aforesaid aspects, the widths of the depletion layers respectively extending from the boundaries between the drain region and the two base regions into the drain region just below the gate electrode (the depths of the depletion layers as measured from the surface of the drain region) can be increased in the OFF state. Thus, the gate-drain capacitance can be reduced to shorten the turn-on time.

The foregoing and other objects, features and effects of the present invention will become more apparent from the following description of the embodiments with reference to the attached drawings.

### BRIEF DESCRIPTION OF THE DRAWINGS

Fig. 1 is a sectional view of a DMOSFET as a semiconductor device according to a preferred embodiment of the present invention.
Fig. 2 is a schematic sectional view illustrating the DMOSFET of Fig. 1 in an OFF state.
Fig. 3 is a sectional view of a DMOSFET as a semiconductor device according to another preferred embodiment of the present invention.
Fig. 4 is a schematic sectional view illustrating the DMOSFET of Fig. 3 in an OFF state.
Fig. 5 is a sectional view of a prior art DMOSFET.
Fig. 6(a) is a schematic sectional view illustrating the DMOSFET of Fig. 5 in an OFF state, and Fig. 6(b) is a schematic sectional view illustrating the DMOSFET of Fig. 5 in an ON state.
Fig. 7 is a circuit diagram of the DMOSFET shown in Fig. 5.

### BEST MODE FOR CARRYING OUT THE INVENTION

Semiconductor devices according to preferred embodiments of the present invention will hereinafter be described with reference to the drawings.

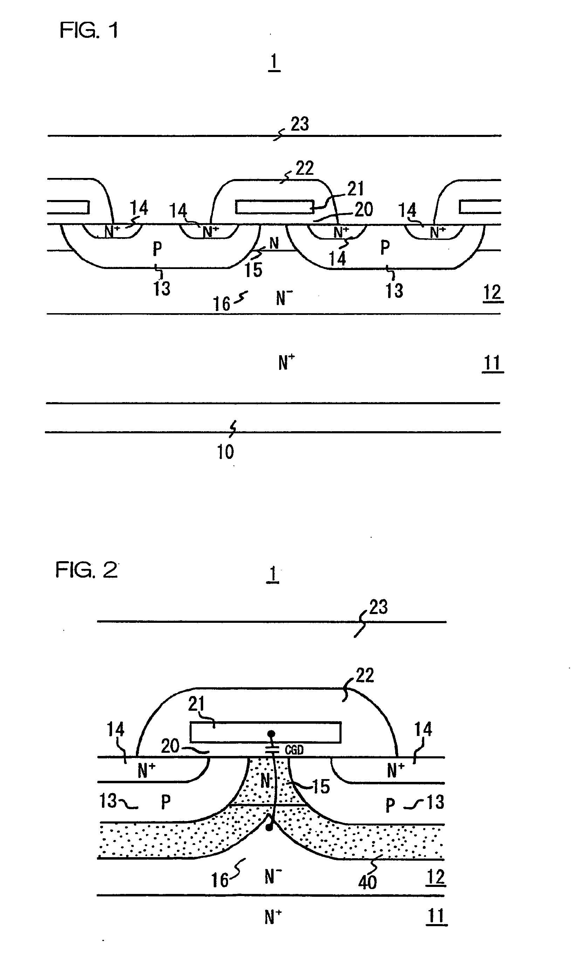

Fig. 1 is a sectional view of a DMOSFET as a semiconductor device according to a preferred embodiment of the present invention. Like the prior art DMOSFET described in PRIOR ART, the DMOSFET 1 includes a semiconductor substrate 11, an epitaxial layer 12, base regions 13, source regions 14, a drain JFET region 15, a drain epitaxial region 16 and a gate electrode 21. The DMOSFET 1 is improved in the impurity concentration of the drain JFET region 15 and the lateral length of the drain JFET region 15 over the prior art DMOSFET.

More specifically, the DMOSFET 1 includes an N⁻-type epitaxial layer 12 formed on a front surface of an N⁺-type semiconductor substrate 11 as having a lower impurity concentration than the semiconductor substrate. A rear surface of the semiconductor substrate 11 is covered with a metal, which serves as a drain electrode 10. At least two P-type diffusion layers serving as the base regions 13 are embedded in a part of a surface portion of the epitaxial layer 12 as being laterally spaced a predetermined distance from each other. Further, two N⁺-type diffusion layers serving as the source regions 14 are embedded in a part of a surface portion of each of the base regions 13. The drain JFET region 15 is defined as a portion of the epitaxial layer 12 located between the two base regions 13, 13. The drain epitaxial region 16 is defined as the other portion of the epitaxial layer 12 present between the drain JFET region 15 and the semiconductor substrate 11. The drain JFET region 15, the drain epitaxial region 16 and the semiconductor substrate 11 constitute a drain region. The drain JFET region 15 is formed as an N-type diffusion layer having a higher impurity concentration than the drain epitaxial region 16. The drain JFET region 15 has a lateral length which is determined by the base regions 13, 13 laterally spaced the predetermined distance from each other and is shorter than that in the prior art.

The gate electrode 21 is provided on the surface of the epitaxial layer 12 with the intervention of a gate insulation film 20. Ends of the gate electrode 21 are respectively opposed to surfaces of the two base regions 13. The gate electrode 21 is covered with an insulation film 22, and a patterned metal interconnection 23 is provided over the insulation film 22. The metal interconnection 23 serves as a source electrode. The metal interconnection 23 is connected to the base regions 13 and the source regions 14 through ohmic contacts via contact holes. The gate electrode 21 is patterned, and ends of the resulting pattern are connected to other metal interconnections.

Although detailed explanation of a production method for the DMOSFET 1 is herein omitted, a difference from a prior art production method is that the N-type diffusion layer for the drain JFET region 15 is formed by an impurity diffusion step or an impurity implantation step before formation of the gate electrode 21. Alternatively, the formation of the N-type diffusion layer may be achieved by epitaxial growth with an increased impurity dose after epitaxial growth of the drain epitaxial region 16.

A specific example will be explained, in which the drain JFET region 15 has an impurity concentration of 14×10¹⁶/cm³ and a lateral length of 0.85 µm and a gate-source voltage V_{GS} is lower than a threshold, i.e., the DMOSFET 1 is in an OFF state. When the drain-source voltage V_{DS} is 20V, the width of the depletion layer is about 0.43 µm. Therefore, depletion layers 40 respectively extending from boundaries between the drain JFET region 15 and the two base regions 13, 13 are connected to each other in the drain JFET region 15 as shown in Fig. 2. Since the drain JFET region 15 is occupied with the depletion layers, it is impossible to distinguish a depletion layer present in a surface portion of the drain JFET region 15 (opposed to the gate electrode 21) from the depletion layers 40 respectively extending from the two base regions 13, 13.

As a result, the gate-drain capacitance C_{GD} is reduced. As described above, the gate-drain capacitance C_{GD} is the sum of the serially connected capacitances of the gate insulation film 20 and the depletion layer extending vertically (or in a depth direction) from the surface of the drain JFET region 15. Since the depletion layer has a greater width than the drain JFET region 15 as measured vertically, the gate-drain capacitance C_{GD} is reduced.

The lateral length of the drain JFET region 15, i.e., the lateral distance between the two base regions 13, is determined so that the depletion layers 40 respectively extending from the base regions 13, 13 are connected to each other. Thus, the gate-drain capacitance C_{GD} can be reduced. As a result, the turn-on time is shortened, thereby permitting high speed switching.

On the other hand, in the aforesaid specific example, the impurity concentration and the cross sectional area of the drain JFET region differ by factors of 3.5 and about 0.28, respectively, from those in the prior art described in PRIOR ART (in which the drain JFET region has an impurity concentration of 4×10¹⁶/cm³ and a lateral length of 3 µm) and hence the product of the cross sectional area and the impurity concentration is generally equivalent to that in the prior art. Therefore, the resistance of the drain JFET region 15 is generally equivalent to that in the prior art. Hence, the ON resistance is also generally equivalent to that in the prior art.

The gate electrode 21 has a stripe pattern. The resistance, which may be increased due to the reduction in the lateral length of the drain JFET region 15, can be compensated for by increasing the impurity concentration of the drain JFET region 15. Thus, an increase in ON resistance can be suppressed.

If the ON resistance can be increased to a certain extent, the drain JFET region 15 may have an impurity concentration equivalent to that of the drain epitaxial region 16, and the drain JFET region may have a lateral length such that the depletion layers 40 from the base regions 13, 13 are connected to each other. This is because a power transistor for use in a DC/DC converter, for example, is not necessarily required to have a lower ON resistance depending on a load connected to an output terminal. This obviates the need for employing the impurity diffusion step or the like for the formation of the drain JFET region 15. More specifically, where the drain JFET region 15 has a lateral length of 1.6 µm and an impurity concentration of 4×10¹⁶/cm³, the ON resistance is increased by a factor of about 1.875 correspondingly to the reduction in the lateral length. On the other hand, since the depletion layer has a width of about 0.8 µm, the depletion layers 40 laterally contact each other in the drain JFET region 15.

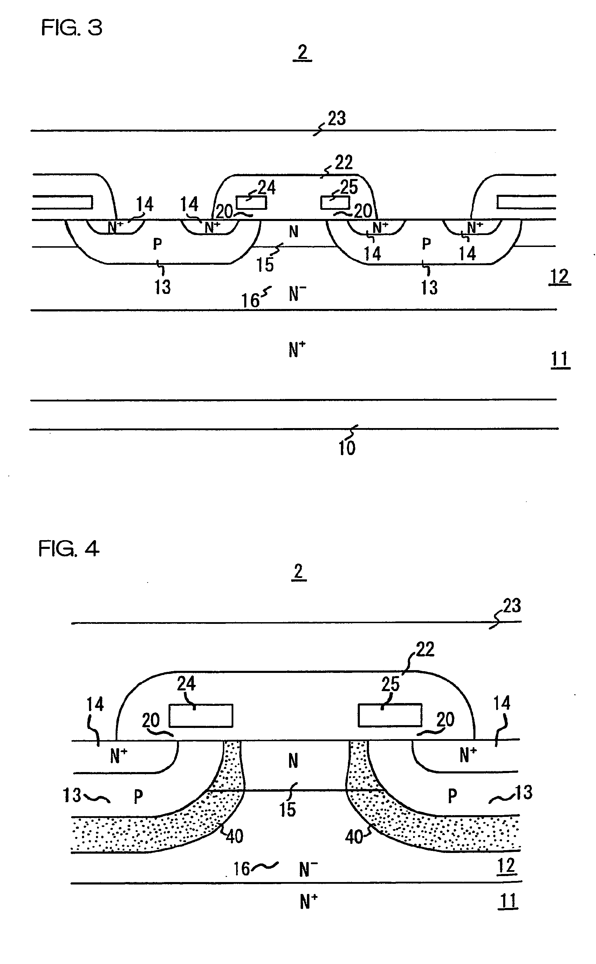

Fig. 3 is a sectional view of a DMOSFET as a semiconductor device according to another preferred embodiment of the present invention. Like the DMOSFET 1, the DMOSFET 2 includes a semiconductor substrate 11, an epitaxial layer 12, at least two base regions (first and second base regions) 13, source regions 14, a drain JFET region 15 and a drain epitaxial region 16. However, the DMOSFET 2 differs from the DMOSFET 1 in the lateral length of the drain JFET region 15 and the shape of the gate electrode. More specifically, the drain JFET region 15 of the DMOSFET 2 has a greater lateral length than the drain JFET region 15 of the DMOSFET 1. Further, a gate electrode including a first gate electrode 24 and a second gate electrode 25 has a shape such as obtained by removing a middle portion of the gate electrode 21 of the DMOSFET 1 and spacing the other portions of the gate electrode 21 from each other.

When the DMOSFET 2 is in an OFF state, depletion layers 40, 40 respectively extending from the first and second base regions 13, 13 spread beyond portions of the drain JFET region 15 opposed to the first gate electrode 24 and the second gate electrode 25 in the drain JFET region 15 as shown in Fig. 4. In other words, the depletion layers 40 spread more deeply than the depth of the drain JFET region 15 just below the first gate electrode 24 and the second gate electrode 25. As a result, the gate-drain capacitance C_{GD} is reduced. Therefore, in the DMOSFET 1, the turn-on time is shortened, thereby achieving high speed switching.

In the DMOSFET 2, there is no need to reduce the lateral length of the drain JFET region 15 as in the DMOSFET 1. Therefore, the impurity concentration may be reduced to some extent to ensure an ON resistance equivalent to that of the DMOSFET 1.

It should be understood that the present invention be not limited to the embodiments described above, but any design modifications may be made within the scope of the present invention as defined by the appended claims. For example, the above explanation of the DMOSFETs is applicable to an IGBT in which a DMOSFET and a bipoloar transistor are equivalently incorporated in a single device. In this case, a collector electrode corresponds to the drain electrode, and an emitter electrode corresponds to the source electrode.

## Claims

1. A semiconductor device comprising:
an epitaxial layer;
two base regions embedded in a surface portion of the epitaxial layer;
source regions respectively embedded in the two base regions;
a drain region including at least a portion of the epitaxial layer excluding the two base regions; and
a gate electrode provided on the epitaxial layer with the intervention of an insulation film with ends thereof respectively opposed to surfaces of the two base regions,
wherein the drain region is arranged so that depletion layers respectively extending from boundaries between the drain region and the two base regions are connected to each other in an OFF state in a portion of the drain region located between the two base regions.

2. A semiconductor device as set forth in claim 1, wherein the portion of the drain region located between the two base regions in the epitaxial layer has a higher impurity concentration than the other portion of the drain region in the epitaxial layer.

3. A semiconductor device as set forth in claim 2,
wherein the epitaxial layer is provided on a front surface of a semiconductor substrate, and
a drain electrode is provided on a rear surface of the semiconductor substrate.

4. A semiconductor device comprising:
an epitaxial layer;
first and second base regions embedded in a surface portion of the epitaxial layer;
a first source region embedded in the first base region;
a second source region embedded in the second base region;
a drain region including at least a portion of the epitaxial layer excluding the first and second base regions;
a first gate electrode provided on the epitaxial layer with the intervention of an insulation film in opposed relation to a surface of the first base region; and
a second gate electrode provided on the epitaxial layer with the intervention of an insulation film in opposed relation to a surface of the second base region and spaced a predetermined distance from the first gate electrode,
wherein a portion of the drain region located between the first base region and the second base region in the epitaxial layer has a higher impurity concentration than the other portion of the drain region in the epitaxial layer, and
in an OFF state, depletion layers respectively extending from boundaries between the drain region and the first and second base regions spread beyond portions of the drain region opposed to the first and second gate electrodes in the portion of the drain region located between the first base region and the second base region in the epitaxial layer.

5. A semiconductor device as set forth in claim 4,
wherein the epitaxial layer is provided on a front surface of a semiconductor substrate, and
a drain electrode is provided on a rear surface of the semiconductor substrate.

6. A semiconductor device comprising:
an epitaxial layer;
first and second base regions embedded in a surface portion of the epitaxial layer;
a first source region embedded in the first base region;
a second source region embedded in the second base region;
a first drain region defined as a portion of the epitaxial layer located between the first base region and the second base region;
a second drain region defined as a portion of the epitaxial layer excluding the first base region, the second base region and the first drain region; and
a gate electrode provided on the epitaxial layer with the intervention of an insulation film with at least a part thereof opposed to the first drain region,
wherein the first drain region has a higher impurity concentration than the second drain region, and
in an OFF state, a depletion layer spreads throughout a portion of the first drain region opposed to the gate electrode.

7. A semiconductor device as set forth in claim 6,
wherein the epitaxial layer is provided on a front surface of a semiconductor substrate, and
a drain electrode is provided on a rear surface of the semiconductor substrate.
